(19) Europäisches Patentamt
European Patent Office
Office européen des brevets

(11) **EP 4 707 836 A1**

(12) **EUROPEAN PATENT APPLICATION**
published in accordance with Art. 153(4) EPC

(43) Date of publication:
**11.03.2026 Bulletin 2026/11**

(21) Application number: **24839985.9**

(22) Date of filing: **03.07.2024**

(51) International Patent Classification (IPC):
$G01R\ 31/396^{(2019.01)}$    $G01R\ 31/385^{(2019.01)}$
$G01R\ 19/30^{(2006.01)}$    $G01R\ 31/367^{(2019.01)}$

(52) Cooperative Patent Classification (CPC):
Y02E 60/10

(86) International application number:
**PCT/KR2024/009413**

(87) International publication number:
**WO 2025/014172 (16.01.2025 Gazette 2025/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.07.2023 KR 20230091278**

(71) Applicant: **LG Energy Solution, Ltd.
Seoul 07335 (KR)**

(72) Inventor: **PARK, Hee Ju
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY MANAGEMENT APPARATUS AND OPERATING METHOD THEREOF**

(57)    A battery management apparatus according to an embodiment disclosed herein includes a voltage measurement unit configured to measure a voltage of each of a plurality of battery cells and a controller configured to calculate a first deviation, which is a deviation between a long moving average and a short moving average of a battery cell voltage of each of the plurality of battery cells, calculate a second deviation, which is a deviation between a long moving average and a short moving average of an average voltage of the plurality of battery cells, and calculate a first diagnosis deviation between the first deviation and the second deviation for each of the plurality of battery cells, diagnose each of the plurality of battery cells based on whether a final diagnosis deviation related to the first diagnosis deviation of each of the plurality of battery cells is at least a first threshold value and based on a time during which the final diagnosis deviation is maintained as being at least a second threshold value.

200

FIG.2

**Description**

**[Technical Field]**

CROSS-REFERENCE TO RELATED APPLICATION

This application claims priority to and the benefit of Korean Patent Application No. 10-2023-0091278 filed in the Korean Intellectual Property Office on July 13, 2023, the entire content of which is incorporated herein by reference.

TECHNICAL FIELD

Embodiments disclosed herein relate to a battery management apparatus and an operating method thereof.

**[Background Art]**

An electric vehicle is supplied with electricity from outside to charge a battery cell, and then a motor is driven by a voltage charged in the battery cell to obtain power. A battery cell undergoes internal deformation and degeneration through various charging and discharging during production and use, with physical/chemical characteristics thereof changing, resulting in venting due to internal short-circuit, external short-circuit, and lithium precipitation or in an under-voltage defect in which a voltage of a battery cell decreases below a certain level.

When a defect occurs inside the battery cell, direct problems may occur in the battery cell, such as deterioration of battery cell performance, the increased possibility of ignition due to leakage of an electrolyte, etc. Thus, a technique for determining whether the battery cell is abnormal is required.

A conventional battery management apparatus may diagnose voltage abnormality of a battery cell by using a voltage deviation of an individual battery cell with respect to an average voltage of battery cells, but this method may not adjust a threshold that is a criterion for diagnosing an abnormal battery cell below a certain level due to its vulnerability to noise, and may not detect an abnormal voltage of a battery cell due to micro-disconnection occurring in an electric vehicle.

**[Disclosure]**

**[Technical Problem]**

Embodiments disclosed herein aim to provide a battery management apparatus and an operating method thereof in which noise of a deviation between a long moving average and a short moving average of a voltage of a battery cell may be removed to accurately diagnose an abnormal battery cell.

Embodiments disclosed herein aim to provide a battery management apparatus and an operating method thereof in which a voltage behavior due to an external resistance or an environment rather than a cause in a cell may be identified.

Technical problems of the embodiments disclosed herein are not limited to the above-described technical problems, and other unmentioned technical problems would be clearly understood by one of ordinary skill in the art from the following description.

**[Technical Solution]**

A battery management apparatus according to an embodiment disclosed herein includes a voltage measurement unit configured to measure a voltage of each of a plurality of battery cells and a controller configured to calculate a first deviation, which is a deviation between a long moving average and a short moving average of a battery cell voltage of each of the plurality of battery cells, calculate a second deviation, which is a deviation between a long moving average and a short moving average of an average voltage of the plurality of battery cells, and calculate a first diagnosis deviation between the first deviation and the second deviation for each of the plurality of battery cells, diagnose each of the plurality of battery cells based on whether a final diagnosis deviation related to the first diagnosis deviation of each of the plurality of battery cells is at least a first threshold value and based on a time during which the final diagnosis deviation is maintained as being at least a second threshold value.

In an embodiment, the controller may be further configured to determine, as a diagnosis battery cell, a battery cell having the final diagnosis deviation that is at least the first threshold value and diagnose that the diagnosis battery cell is abnormal when the final diagnosis deviation of the diagnosis battery cell is maintained as being at least the second threshold value during a first time from a diagnosis point in time.

In an embodiment, the controller may be further configured to diagnose that the diagnosis battery cell is misdiagnosed when the final diagnosis deviation of the diagnosis battery cell is not maintained as being at least the second threshold value during a first time from a diagnosis point in time.

In an embodiment, the first time may be determined in relation to a time during which the long moving average is calculated.

In an embodiment, the second threshold value may be less than the first threshold value, and the second threshold value may be determined based on the first threshold value.

In an embodiment, the controller may be further configured to calculate a second diagnosis deviation of each of the plurality of battery cells by normalizing the first diagnosis deviation of each of the plurality of battery cells, and calculate a second diagnosis deviation of each of the plurality of battery cells as the final diagnosis deviation.

An operating method of a battery management apparatus according to an embodiment disclosed herein includes measuring a voltage of each of a plurality of battery cells, calculating a first deviation, which is a deviation between a long moving average and a short moving average of a battery cell voltage of each of the plurality of battery cells, calculating a second deviation, which is a deviation between a long moving average and a short moving average of an average voltage of the plurality of battery cells, and calculating a first diagnosis deviation between the first deviation and the second deviation for each of the plurality of battery cells, and diagnosing each of the plurality of battery cells based on whether a final diagnosis deviation related to the first diagnosis deviation of each of the plurality of battery cells is at least a first threshold value and based on a time during which the final diagnosis deviation is maintained as being at least a second threshold value.

In an embodiment, the diagnosing of each of the plurality of battery cells based on whether the final diagnosis deviation related to the first diagnosis deviation of each of the plurality of battery cells is at least the first threshold value and based on the time during which the final diagnosis deviation is not maintained as being at least the second threshold value may include determining, as a diagnosis battery cell, a battery cell having the final diagnosis deviation that is at least the first threshold value, diagnosing that the diagnosis battery cell is abnormal when the final diagnosis deviation of the diagnosis battery cell is maintained as being at least the second threshold value during a first time from a diagnosis point in time, and diagnosing that the diagnosis battery cell is misdiagnosed when the final diagnosis deviation of the diagnosis battery cell is maintained as being at least the second threshold value during a first time from a diagnosis point in time.

In an embodiment, the first time may be determined in relation to a time during which the long moving average is calculated.

In an embodiment, the second threshold value may be less than the first threshold value, and the second threshold value may be determined based on the first threshold value.

In an embodiment, the diagnosing of each of the plurality of battery cells based on whether the final diagnosis deviation related to the first diagnosis deviation of each of the plurality of battery cells is at least the first threshold value and based on the time during which the final diagnosis deviation is maintained as being at least the second threshold value may include calculating a second diagnosis deviation of each of the plurality of battery cells by normalizing the first diagnosis deviation of each of the plurality of battery cells and calculating a second diagnosis deviation of each of the plurality of battery cells as the final diagnosis deviation.

### [Advantageous Effects]

The battery management apparatus and the operating method thereof according to an embodiment disclosed herein may accurately diagnose an abnormal battery cell by removing noise of a deviation between a long moving average and a short moving average of a voltage of a battery cell.

In addition, the battery management apparatus and the operating method thereof according to an embodiment disclosed herein may analyze a deviation result of a long moving average and a short moving average to distinguish a voltage behavior due to an external environment of a battery cell from a voltage behavior due to actual abnormality.

Moreover, the battery management system and the operating method thereof according to an embodiment disclosed herein may reduce a misdiagnosis rate due to an external factor.

Moreover, various effects recognized directly or indirectly from the disclosure may be provided.

### [Description of Drawings]

FIG. 1 illustrates a battery cell pack according to an embodiment disclosed herein.
FIG. 2 is a block diagram illustrating a configuration of a battery management apparatus, according to an embodiment disclosed herein.
FIG. 3 is a graph showing a voltage of a battery cell according to an embodiment disclosed herein.
FIG. 4 is a flowchart illustrating a method of diagnosing a battery cell of a controller, according to an embodiment disclosed herein.

FIGS. 5A to 5E illustrate an example to distinguish a voltage behavior due to an external environment of a battery cell from a voltage behavior due to actual abnormality, according to another embodiment disclosed herein.

FIG. 6 is a block diagram showing a hardware configuration of a computing system for performing an operating method of a battery management apparatus, according to an embodiment disclosed herein.

**[Mode for Invention]**

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

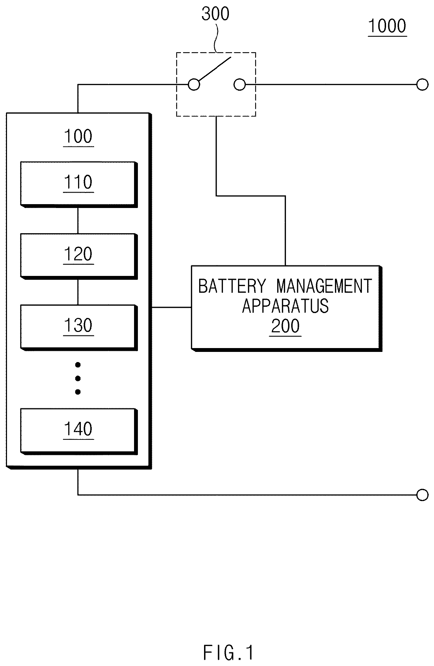

FIG. 1 illustrates a battery cell pack according to an embodiment disclosed herein.

Referring to FIG. 1, a battery cell pack 1000 according to an embodiment disclosed herein may include a battery cell module 100, a battery management apparatus 200, and a relay 300. According to various embodiments, the battery cell module 100 may be a battery cell, and in this case, the battery cell pack 1000 may have a cell-to-pack structure.

Meanwhile, although one battery cell module 100 is illustrated in FIG. 1, the battery cell module 100 may be configured in plural and the battery cell pack 1000 may have a stacked structure of a plurality of battery cell modules, according to an embodiment. The battery cell module 100 may include a plurality of battery cells 110, 120, 130, and 140. Although the plurality of battery cells are illustrated as four in FIG. 1, the present disclosure is not limited thereto, and the battery cell module 100 may include n battery cells (n is a natural number equal to or greater than 2).

The battery cell module 100 may supply power to a target device (not shown). To this end, the battery cell module 100 may be electrically connected to the target device. Herein, the target device may include an electrical, electronic, or mechanical device that operates by receiving power from the battery cell pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery cell available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery cell module 100 is illustrated in FIG. 1, the battery cell module 100 may be configured in plural according to an embodiment.

The battery management apparatus (or a battery management system (BMS)) 200 may manage and/or control a state and/or an operation of the battery cell module 100. For example, the battery management apparatus 200 may manage and/or control the states and/or operations of the plurality of battery cells 110, 120, 130, and 140 included in the battery cell module 100. The battery management apparatus 200 may manage charging and/or discharging of the battery cell module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery cell pack 1000.

In addition, the battery management apparatus 200 may monitor a voltage, a current, a temperature, etc., of the battery cell module 100 and/or each of the plurality of battery cells 110, 120, 130, and 140 included in the battery cell module 100. A sensor or various measurement modules for monitoring performed by the battery management apparatus 200, which are not shown, may be additionally installed in the battery cell module 100, a charging/discharging path, any position of the battery cell module 100, etc. The battery management apparatus 200 may calculate a parameter indicating a state of the battery cell module 100, e.g., a state of charge (SOC), a state of health (SOH) etc., based on a measurement value such as monitored voltage, current, temperature, etc.

For the plurality of battery cells 110, 120, 130, and 140, as a period of use or the number of times of use increases, a capacity may decrease, internal resistance may increase, and various factors of the battery may change. The battery management apparatus 200 may diagnose an abnormal phenomenon inside the plurality of battery cells 110, 120, 130, and 140 based on data of various factors changing with deterioration of the battery cells.

When a defect occurs in a battery cell due to various causes such as a defect in a production stage, internal deformation and degeneration through a plurality of charging and discharging, an external impact, etc., a voltage change may occur more quickly and significantly in comparison to a normal battery cell. By using a phenomenon in which a voltage change is faster and more significant in a battery cell having an internal defect occurring than in a normal battery cell in an idle period, the battery management apparatus 200 may compare voltage data of the idle period of each of the plurality of battery cells 110, 120, 130, and 140 with statistic normal voltage data of an idle period of a normal battery cell to diagnose an abnormal battery cell among the plurality of battery cells 110, 120, 130, and 140.

The battery management apparatus 200 may calculate an average of voltages of the plurality of battery cells 110, 120, 130, and 140 and a deviation dV of the voltage of each of the plurality of battery cells 110, 120, 130, and 140. The battery management apparatus 200 may determine an abnormal behavior of a voltage of at least one battery cell among the plurality of battery cells 110, 120, 130, and 140 by using the deviation of the voltage of each of the plurality of battery cells 110, 120, 130, and 140, thereby diagnosing a corresponding battery cell.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

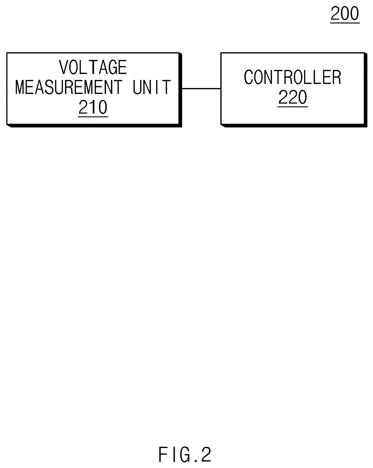

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a voltage measurement unit 210 and a controller 220.

The voltage measurement unit 210 may calculate the voltage of each of the plurality of battery cells 110, 120, 130, and 140. The voltage measurement unit 210 may calculate the voltage of each of the plurality of battery cells 110, 120, 130, and 140 for each unit time to calculate time-series data of the voltage of each of the plurality of battery cells 110, 120, 130, and 140. According to an embodiment, the voltage measurement unit 210 may continuously calculate voltage rise and drop and long-term relaxation data of the plurality of battery cells 110, 120, 130, and 140 in charging, an idle period after charging, discharging, and an idle period after discharging.

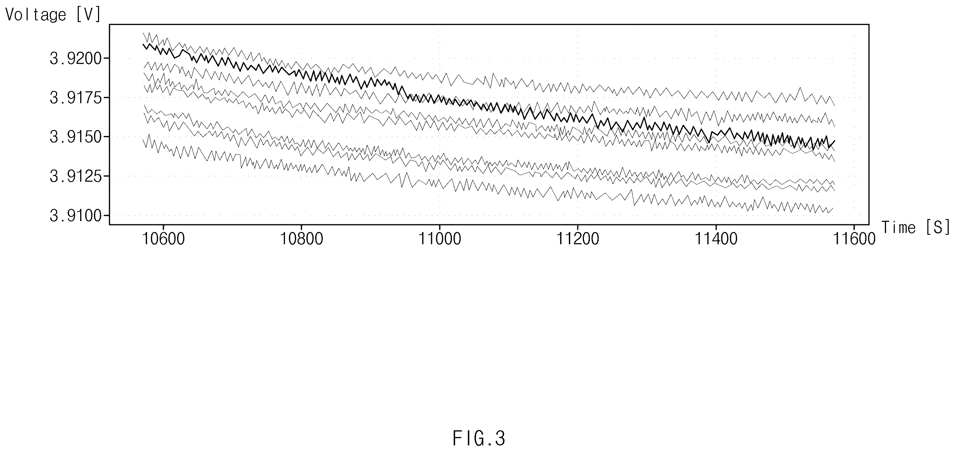

FIG. 3 is a graph showing a voltage of a battery cell according to an embodiment disclosed herein.

Referring to FIG. 3, the voltage measurement unit 210 may calculate the time-series data of the voltage of each of the plurality of battery cells 110, 120, 130, and 140 by measuring the voltages of the plurality of battery cells 110, 120, 130, and 140 in charging, an idle period after charging, discharging, and an idle period after discharging. The voltage measurement unit 210 may generate a graph indicating a voltage change of each of the plurality of battery cells 110, 120, 130, and 140 by measuring the voltage of each of the plurality of battery cells 110, 120, 130, and 140 for each unit time.

The controller 220 may calculate a moving average of the voltage of each of the plurality of battery cells 110, 120, 130, and 140. Herein, the moving average may be an average of some data extracted during movement on a window of a certain size among the entire data. Herein, the window may be a reference period for determining some of the entire data extracted for use. A start point of the window may be a point preceding the present point by a reference time, an end point of the window may be the present point. For example, when the window corresponds to one week, the controller 220 may extract data obtained during the recent one week from the present point from among the entire data.

The controller 220 may calculate the moving average of the voltage of each of the plurality of battery cells 110, 120, 130, and 140 by using voltage data extracted during movement in the window from among the entire voltage data of each of the plurality of battery cells 110, 120, 130, and 140. The controller 220 may calculate the continuous moving average of the voltage of each of the plurality of battery cells 110, 120, 130, and 140 by using voltage data continuously extracted during movement in the window from among the entire voltage data of each of the plurality of battery cells 110, 120, 130, and 140. For example, the controller 220 may calculate the moving average of the voltage of each of the plurality of battery cells 110, 120, 130, and 140 by applying any one of a simple moving average, a weighted moving average, or an exponential moving average (EMA) to the entire voltage data of each of the plurality of battery cells 110, 120, 130, and 140.

According to an embodiment, the controller 220 may calculate the EMA of the voltage of each of the plurality of battery cells 110, 120, 130, and 140 by applying the EMA to the entire voltage data of each of the plurality of battery cells 110, 120, 130, and 140. The EMA refers to a sort of weighted moving averaging in which a higher weight value is applied to the recent data, while using data of all the past periods.

The controller 220 may calculate a plurality of moving averages having different window sizes by using the voltage data of each of the plurality of battery cells 110, 120, 130, and 140. According to an embodiment, the controller 220 may calculate a long moving average having a long window length and a short moving average having a short window length by using the entire voltage data of each of the plurality of battery cells 110, 120, 130, and 140. For example, the window size of the long moving average may include 100 seconds, and the window size of the short moving average may include 10 seconds. For example, the controller 220 may calculate the long moving average of each of the plurality of battery cells 110, 120, 130, and 140 by using voltage data obtained during the recent 100 seconds from calculation using the voltage data of each of the plurality of battery cells 110, 120, 130, and 140, and calculate the short moving average of each of the plurality of battery cells 110, 120, 130, and 140 by using the voltage data obtained for the recent 10 seconds from the calculation.

The controller 220 may analyze a long voltage change trend and a short voltage change trend of each of the plurality of battery cells 110, 120, 130, and 140 by using continuous long moving average V_LMA and short moving average V_SMA of each of the plurality of battery cells 110, 120, 130, and 140. The controller 220 may diagnose whether a voltage of each of the plurality of battery cells is abnormal, by using the long moving average V_LMA and the short moving average V_SMA of each of the plurality of battery cells 110, 120, 130, and 140.

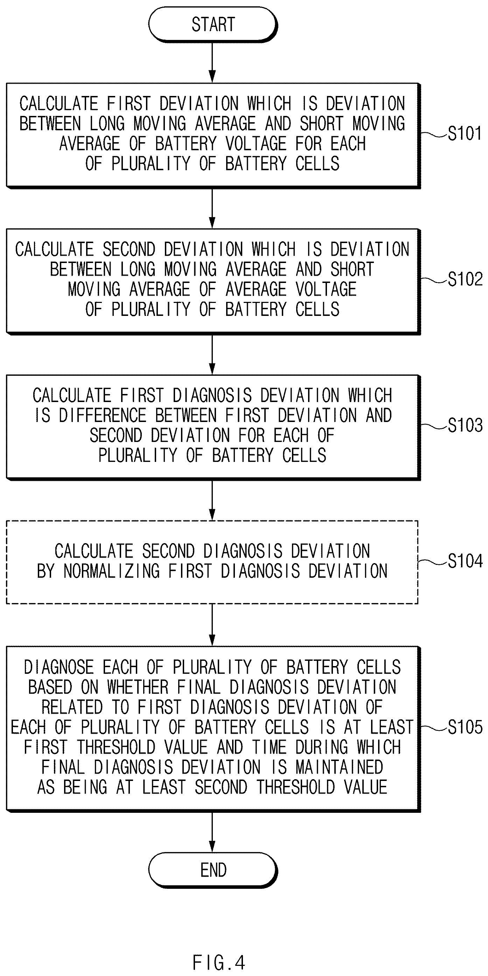

FIG. 4 is a flowchart illustrating a method of diagnosing a battery cell of a controller, according to an embodiment disclosed herein.

Hereinbelow, a battery cell diagnosis method of the controller will be described in detail with reference to FIG. 4.

In operation S101, the controller 220 may calculate a plurality of first deviations V_LMA - V_SMA which is a deviation of the long moving average V_LMA and the short moving average V_SMA of the voltage of each of the plurality of battery cells 110, 120, 130, and 140. In operation S101, the controller 220 may continuously calculate the first deviation V_LMA - V_SMA of each of the plurality of battery cells 110, 120, 130, and 140 calculated during a unit time. In operation S101, that is, the controller 220 may continuously calculate a deviation between a long behavior and a short behavior of each of the plurality of battery cells 110, 120, 130, and 140.

In operation S102, the controller 220 may calculate a long moving average and a short moving average of an average voltage V_avg of the plurality of battery cells 110, 120, 130, and 140. Herein, the average voltage V_avg of the plurality of battery cells 110, 120, 130, and 140 may include a mean or a median of the voltages of the plurality of battery cells 110, 120, 130, and 140.

In operation S102, the controller 220 may continuously calculate the average voltage V_avg of the plurality of battery cells 110, 120, 130, and 140 for each unit time, and calculate the long moving average and the short moving average of the average voltage V_avg of the plurality of battery cells 110, 120, 130, and 140 by using the average voltage V_avg of the plurality of battery cells 110, 120, 130, and 140. Herein, a window size of the long moving average of the average voltage V_avg of the plurality of battery cells 110, 120, 130, and 140 may equal a window size of the long moving average V_LMA of the voltage of each of the plurality of battery cells 110, 120, 130, and 140. Herein, a window size of the short moving average of the average voltage V_avg of the plurality of battery cells 110, 120, 130, and 140 may equal a window size of the short moving average V_SMA of the voltage of each of the plurality of battery cells 110, 120, 130, and 140.

In operation S102, the controller 220 may calculate a second deviation that is a deviation between the long moving average and the short moving average of the average voltage V_avg of the plurality of battery cells 110, 120, 130, and 140. In operation S102, the controller 220 may continuously calculate the second deviation of the plurality of battery cells 110, 120, 130, and 140 for each unit time. That is, the controller 220 may calculate a deviation of a long behavior and a short behavior of the average voltage V_avg of the plurality of battery cells 110, 120, 130, and 140.

In operation S103, the controller 220 may calculate a first diagnosis deviation D1 of each of the plurality of battery cells 110, 120, 130, and 140, which is a deviation of the plurality of first deviations V_LMA - V_SMA and the second deviation.

In operation S103, specifically, the controller 220 may calculate the first diagnosis deviation D1 of each of the plurality of battery cells 110, 120, 130, and 140, based on Equation 1.

$$\text{First Diagnosis Deviation (D1)} = \text{Second Deviation} - \text{First Voltage} = (V_{avg}\text{-LMA} - V_{avg}\text{-SMA}) - (V\_LMA - V\_SMA) \qquad \text{[Equation 1]}$$

Referring to Equation 1, the controller 220 may calculate the deviation of the plurality of first deviations V_LMA - V_SMA and the second deviation as the first diagnosis deviation D1 of each of the plurality of battery cells 110, 120, 130, and 140.

In operation S104, the controller 220 may calculate a second diagnosis deviation D2 of each of the plurality of battery cells 110, 120, 130, and 140 by normalizing the first diagnosis deviation D1 of each of the plurality of battery cells 110, 120, 130, and 140. According to an embodiment, operation S104 may be omitted.

In operation S105, the controller 220 may diagnose each of the plurality of battery cells based on whether a final diagnosis deviation related to the first diagnosis deviation of each of the plurality of battery cells is at least a first threshold value and based on a time during which the final diagnosis deviation is maintained as being at least a second threshold value.

According to an embodiment, the controller 220 may determine that a battery cell having the final diagnosis deviation being at least the first threshold value is a diagnosis battery cell. For example, the final diagnosis deviation may be generated based on the first diagnosis deviation.

According to an embodiment, the controller 220 may diagnose that the diagnosis battery cell is abnormal when the final diagnosis deviation of the diagnosis battery cell is maintained as being at least the second threshold value during a first time from a diagnosis point in time. According to another embodiment, the controller 220 may diagnose that the diagnosis battery cell is misdiagnosed when the final diagnosis deviation of the diagnosis battery cell is maintained as being at least the second threshold value during the first time from the diagnosis point in time.

That is, the battery management apparatus 200 according to an embodiment disclosed herein may determine that corresponding diagnosis is misdiagnosis caused by an external factor when the final diagnosis deviation of the diagnosis battery cell is not maintained as at least the second threshold value during the first time from the diagnosis point in time. In addition, the battery management apparatus 200 may determine that corresponding diagnosis is normal abnormality diagnosis rather than the misdiagnosis caused by an external factor when the final diagnosis deviation of the diagnosis battery cell is maintained as at least the second threshold value during the first time from the diagnosis point in time.

According to an embodiment, the first time may be determined in relation to a time during which the long moving average is calculated. For example, the first time may be determined as, but not limited to, a value corresponding to 70 % of the time during which the long moving average is calculated.

According to an embodiment, the second threshold value may be less than the first threshold value and may be determined based on the first threshold value. For example, the second threshold value may be determined as, but not limited to, being a half of the first threshold value.

According to an embodiment, the controller 220 may calculate a second diagnosis deviation of each of the plurality of battery cells by normalizing the first diagnosis deviation of each of the plurality of battery cells. For example, the controller 220 may calculate the second diagnosis deviation of each of the plurality of battery cells and compare the second diagnosis deviation with the first threshold value and the second threshold value.

That is, according to various embodiments, in operation S105, the controller 220 may diagnose the plurality of battery cells based on the first diagnosis deviation or the second diagnosis deviation to determine the diagnosis battery cell and calculate the final diagnosis deviation. In addition, based on a time during which the final diagnosis deviation of the diagnosis battery cell is maintained as being at least the second threshold value, the controller 220 may determine whether the diagnosis battery cell is diagnosed normally.

According to an embodiment, the controller 220 may identify a time during which the first diagnosis deviation or the second diagnosis deviation of the diagnosis battery cell is maintained as being at least the second threshold value, and determine, based on the time, whether the diagnosis battery cell is diagnosed normally. That is, the final diagnosis deviation may include the first diagnosis deviation or the second diagnosis deviation.

After diagnosing the at least one of the plurality of battery cells 110, 120, 130, and 140, the controller 220 may track and monitor whether a defect of the battery cell, such as internal short-circuit, external short-circuit, lithium precipitation, etc., occurs.

When the controller 220 determines that a defect occurs in the battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

As described above, the battery management apparatus 200 according to an embodiment disclosed herein may accurately diagnose an abnormal battery cell by removing noise of a deviation between a long moving average and a short moving average of a voltage of a battery cell.

In a conventional battery management apparatus, an abnormal behavior signal of a voltage of each battery cell is distorted using a deviation of a voltage of each battery cell with respect to an average voltage of battery cells and there is a possibility of misdiagnosis due to noise data, but the battery management apparatus 200 according to an embodiment disclosed herein may minimize distortion of the voltage of the battery cell by using the deviation of the long moving average and the short moving average of the voltage of each battery cell, and remove noise data, thereby improving the accuracy of diagnosis.

The battery management apparatus 200 may early diagnose the battery cell having the abnormal voltage behavior occurring by using the deviation of the long moving average and the short moving average of the voltage of the battery cell, thereby securing safety and reliability of the battery cell energy. In addition, the battery management apparatus 200 may does not need separation of the battery cell because of diagnosing the battery cell having the abnormal voltage behavior occurring in a state of the battery cell mounted on the vehicle, thereby rapidly and conveniently diagnosing the battery cell.

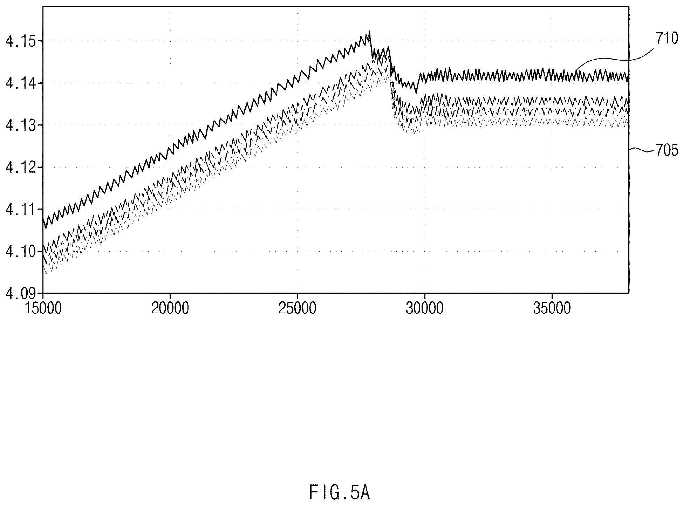

FIGS. 5A to 5E illustrate an example to distinguish a voltage behavior due to an external environment of a battery cell from a voltage behavior due to actual abnormality, according to another embodiment disclosed herein.

Referring to FIG. 5A, a battery management apparatus 200 may obtain a voltage behavior 705 of each of a plurality of battery cells. In this case, the battery management apparatus 200 may also obtain a voltage behavior 710 of a first battery cell.

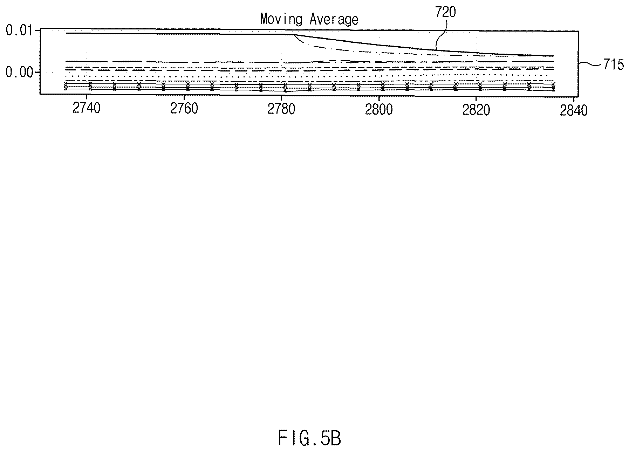

Referring to FIG. 5B, the battery management apparatus 200 may calculate a long moving average and a short moving average 715 based on the voltage behavior 705 of each of the plurality of battery cells. In this case, the battery management apparatus 200 may calculate a long moving average and a short moving average 720 of the first battery cell.

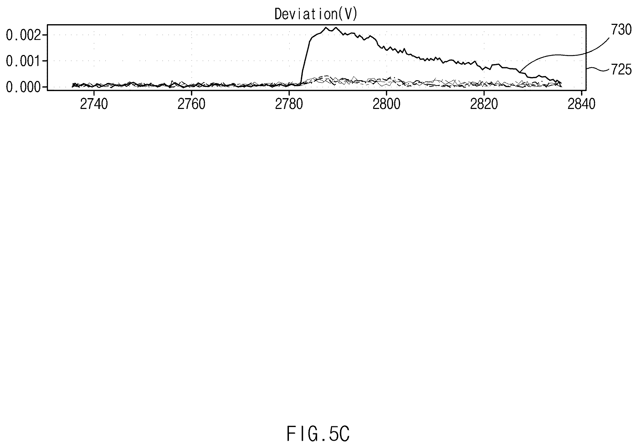

Referring to FIG. 5C, the battery management apparatus 200 may calculate a deviation 725 of a long moving average and a short moving average of each of the plurality of battery cells. In this case, the battery management apparatus 200 may calculate a deviation 730 of the long moving average and the short moving average of the first battery cell. According to an embodiment, the battery management apparatus 200 may compare the deviation of the long moving average and the short moving average of each of the plurality of battery cells with a first threshold value to determine the first battery cell as a diagnosis battery cell.

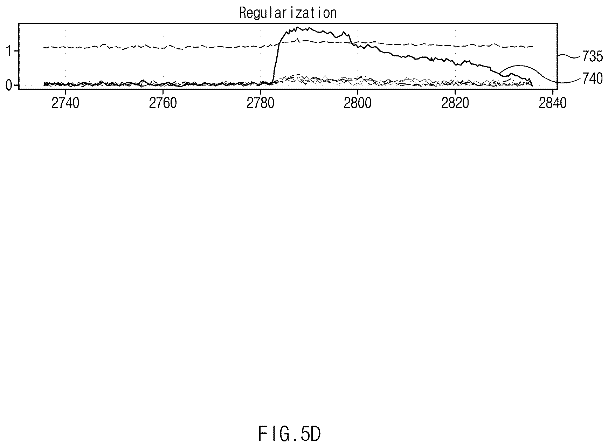

Referring to FIG. 5D, the battery management apparatus 200 may calculate a normalized value 735 of the deviation of the long moving average and the short moving average of each of the plurality of battery cells. In this case, the battery management apparatus 200 may calculate a normalized value 740 of the long moving average and the short moving average of the first battery cell. According to an embodiment, the battery management apparatus 200 may compare the normalized value of the deviation of the long moving average and the short moving average of each of the plurality of battery cells with the first threshold value to determine the first battery cell as the diagnosis battery cell.

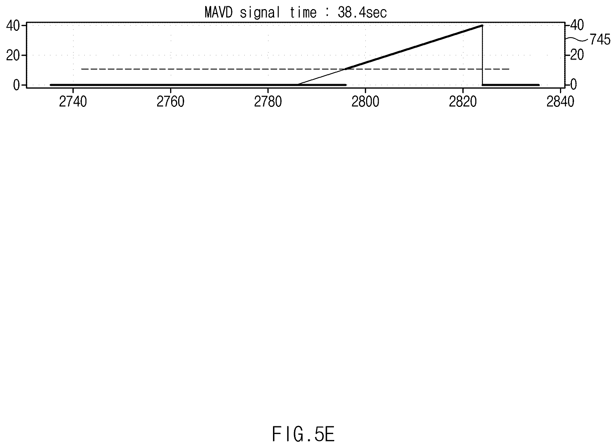

Referring to FIG. 5E, when the first battery cell is determined as the diagnosis battery cell, the battery management apparatus 200 may identify a time 745 during which a deviation 730 of a long moving average and a short moving average of the first battery cell is maintained as being at least the second threshold value.

According to an embodiment, the battery management apparatus 200 may identify a time 745 during which the normalized value 740 of the long moving average and the short moving average of the first battery cell is maintained as being at least the second threshold value.

The battery management apparatus 200 may determine that the first battery cell is diagnosed normally when the time 745 during which the normalized value 740 is maintained as being at least the second threshold value is at least a first time. In another example, the battery management apparatus 200 may determine that the first battery cell is misdiagnosed when the time 745 during which the normalized value 740 is maintained as being at least the second threshold value is less than a first time.

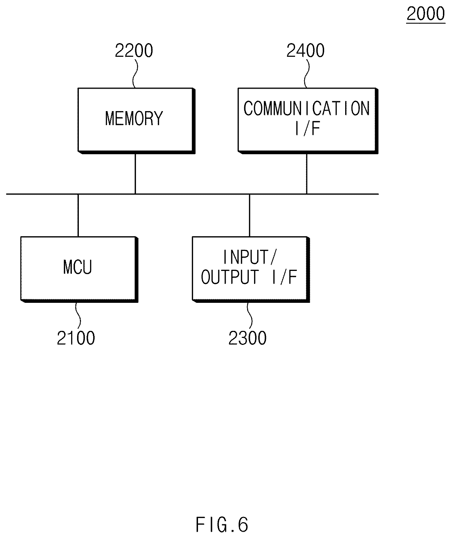

FIG. 6 is a block diagram showing a hardware configuration of a computing system for performing an operating method of a battery management apparatus, according to an embodiment disclosed herein.

Referring to FIG. 6, a computing system 2000 according to an embodiment disclosed herein may include an MCU 2100, a memory 2200, an input/output I/F 2300, and a communication I/F 2400.

The MCU 2100 may be a processor that executes various programs (e.g., a battery voltage deviation analysis program, etc.) stored in the memory 2200, processes various data through these programs, and perform the above-described functions of the battery management apparatus 200 shown in FIG. 2.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for voltage deviation diagnosis, misdiagnosis determination, and abnormality diagnosis or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

[Description of Symbols]

1000: Battery Cell Pack
100: Battery Cell Module
110: First Battery Cell
120: Second Battery Cell
130: Third Battery Cell
140: Fourth Battery Cell
200: Battery Management Apparatus
210: Voltage Measuring Unit
220: Controller
300: Relay
2000: Computing System
2100: MCU
2200: Memory
2300: Input/Output I/F
2400: Communication I/F

**Claims**

1. A battery management apparatus comprising:

   a voltage measurement unit configured to measure a voltage of each of a plurality of battery cells; and
   a controller configured to:

   calculate a first deviation, which is a deviation between a long moving average and a short moving average of a battery cell voltage of each of the plurality of battery cells, calculate a second deviation, which is a deviation between a long moving average and a short moving average of an average voltage of the plurality of battery cells, and calculate a first diagnosis deviation between the first deviation and the second deviation for each of the plurality of battery cells; and
   diagnose each of the plurality of battery cells based on whether a final diagnosis deviation related to the first diagnosis deviation of each of the plurality of battery cells is at least a first threshold value and based on a time during which the final diagnosis deviation is maintained as being at least a second threshold value.

2. The battery management apparatus of claim 1, wherein the controller is further configured to:

   determine, as a diagnosis battery cell, a battery cell having the final diagnosis deviation that is at least the first threshold value; and
   diagnose that the diagnosis battery cell is abnormal when the final diagnosis deviation of the diagnosis battery cell is maintained as being at least the second threshold value during a first time from a diagnosis point in time.

3. The battery management apparatus of claim 2, wherein the controller is further configured to diagnose that the diagnosis battery cell is misdiagnosed when the final diagnosis deviation of the diagnosis battery cell is not maintained as being at least the second threshold value during a first time from a diagnosis point in time.

4. The battery management apparatus of claim 3, wherein the first time is determined in relation to a time during which the long moving average is calculated.

5. The battery management apparatus of claim 1, wherein the second threshold value is less than the first threshold value, and
   the second threshold value is determined based on the first threshold value.

6. The battery management apparatus of claim 1, wherein the controller is further configured to:

   calculate a second diagnosis deviation of each of the plurality of battery cells by normalizing the first diagnosis deviation of each of the plurality of battery cells; and
calculate a second diagnosis deviation of each of the plurality of battery cells as the final diagnosis deviation.

7. An operating method of a battery management apparatus, the operating method comprising:

measuring a voltage of each of a plurality of battery cells;
calculating a first deviation, which is a deviation between a long moving average and a short moving average of a battery cell voltage of each of the plurality of battery cells, calculating a second deviation, which is a deviation between a long moving average and a short moving average of an average voltage of the plurality of battery cells, and calculating a first diagnosis deviation between the first deviation and the second deviation for each of the plurality of battery cells; and
diagnosing each of the plurality of battery cells based on whether a final diagnosis deviation related to the first diagnosis deviation of each of the plurality of battery cells is at least a first threshold value and based on a time during which the final diagnosis deviation is maintained as being at least a second threshold value.

8. The operating method of claim 7, wherein the diagnosing of each of the plurality of battery cells based on whether the final diagnosis deviation related to the first diagnosis deviation of each of the plurality of battery cells is at least the first threshold value and based on the time during which the final diagnosis deviation is maintained as being at least the second threshold value comprises:

determining, as a diagnosis battery cell, a battery cell having the final diagnosis deviation that is at least the first threshold value;
diagnosing that the diagnosis battery cell is abnormal when the final diagnosis deviation of the diagnosis battery cell is maintained as being at least the second threshold value during a first time from a diagnosis point in time; and
diagnosing that the diagnosis battery cell is misdiagnosed when the final diagnosis deviation of the diagnosis battery cell is not maintained as being at least the second threshold value during a first time from a diagnosis point in time.

9. The operating method of claim 8, wherein the first time is determined in relation to a time during which the long moving average is calculated.

10. The operating method of claim 7, wherein the second threshold value is less than the first threshold value, and the second threshold value is determined based on the first threshold value.

11. The operating method of claim 7, wherein the diagnosing of each of the plurality of battery cells based on whether the final diagnosis deviation related to the first diagnosis deviation of each of the plurality of battery cells is at least the first threshold value and based on the time during which the final diagnosis deviation is maintained as being at least the second threshold value comprises:

calculating a second diagnosis deviation of each of the plurality of battery cells by normalizing the first diagnosis deviation of each of the plurality of battery cells; and
calculating a second diagnosis deviation of each of the plurality of battery cells as the final diagnosis deviation.

300

1000

100

110

120

130

⋮

140

BATTERY MANAGEMENT
APPARATUS
200

FIG.1

200

```
┌─────────────────────────┐        ┌─────────────────────┐
│        VOLTAGE          │        │     CONTROLLER      │
│   MEASUREMENT UNIT      │────────│        220          │
│          210            │        │                     │
└─────────────────────────┘        └─────────────────────┘
```

FIG.2

FIG.3

START

CALCULATE FIRST DEVIATION WHICH IS DEVIATION
BETWEEN LONG MOVING AVERAGE AND SHORT MOVING
AVERAGE OF BATTERY VOLTAGE FOR EACH
OF PLURALITY OF BATTERY CELLS ⟋S101

CALCULATE SECOND DEVIATION WHICH IS DEVIATION
BETWEEN LONG MOVING AVERAGE AND SHORT
MOVING AVERAGE OF AVERAGE VOLTAGE
OF PLURALITY OF BATTERY CELLS ⟋S102

CALCULATE FIRST DIAGNOSIS DEVIATION WHICH
IS DIFFERENCE BETWEEN FIRST DEVIATION AND
SECOND DEVIATION FOR EACH OF
PLURALITY OF BATTERY CELLS ⟋S103

CALCULATE SECOND DIAGNOSIS DEVIATION
BY NORMALIZING FIRST DIAGNOSIS DEVIATION ⟋S104

DIAGNOSE EACH OF PLURALITY OF BATTERY CELLS
BASED ON WHETHER FINAL DIAGNOSIS DEVIATION
RELATED TO FIRST DIAGNOSIS DEVIATION OF
EACH OF PLURALITY OF BATTERY CELLS IS AT LEAST ⟋S105
FIRST THRESHOLD VALUE AND TIME DURING WHICH
FINAL DIAGNOSIS DEVIATION IS MAINTAINED
AS BEING AT LEAST SECOND THRESHOLD VALUE

END

FIG.4

FIG.5A

FIG.5B

FIG.5C

FIG.5D

MAVD signal time : 38.4sec

FIG.5E

2000

2200                    2400

```
+------------------+    +------------------+
|                  |    | COMMUNICATION    |
|     MEMORY       |    |      I/F         |
|                  |    |                  |
+------------------+    +------------------+
```

```
+------------------+    +------------------+
|                  |    | INPUT/           |
|      MCU         |    | OUTPUT  I/F      |
|                  |    |                  |
+------------------+    +------------------+
```

2100                    2300

FIG.6

## INTERNATIONAL SEARCH REPORT

| International application No. |
|---|
| **PCT/KR2024/009413** |

**A.    CLASSIFICATION OF SUBJECT MATTER**

**G01R 31/396**(2019.01)i; **G01R 31/385**(2019.01)i; **G01R 19/30**(2006.01)i; **G01R 31/367**(2019.01)i

According to International Patent Classification (IPC) or to both national classification and IPC

**B.      FIELDS SEARCHED**

Minimum documentation searched (classification system followed by classification symbols)

G01R 31/396(2019.01); G01R 19/00(2006.01); G01R 31/367(2019.01); G01R 31/371(2019.01); G01R 31/392(2019.01); G01R 31/52(2020.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 장기 이동 평균값(long term moving average), 단기 이동 평균값(short term moving average), 진단(diagnosis), 편차(deviation)

**C.      DOCUMENTS CONSIDERED TO BE RELEVANT**

| Category* | Citation of document, with indication, where appropriate, of the relevant passages | Relevant to claim No. |
|---|---|---|
| Y | KR 10-2022-0074797 A (LG ENERGY SOLUTION, LTD.) 03 June 2022 (2022-06-03) See paragraphs [0012]-[0014] and [0020]; claim 1; and figure 1. | 1-3,5-8,10-11 |
| A | | 4,9 |
| Y | KR 10-2023-0052763 A (LG ENERGY SOLUTION, LTD.) 20 April 2023 (2023-04-20) See paragraph [0014]; claim 1; and figure 1. | 1-3,5-8,10-11 |
| A | KR 10-2023-0003838 A (KOOKMIN UNIVERSITY INDUSTRY ACADEMY COOPERATION FOUNDATION) 06 January 2023 (2023-01-06) See paragraph [0033]; and figure 1. | 1-11 |
| A | KR 10-2023-0073447 A (WONIK PNE CO., LTD.) 26 May 2023 (2023-05-26) See paragraphs [0017]-[0028]; and figure 1. | 1-11 |

☑ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **10 October 2024** | **10 October 2024** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2024/009413**

| C. | DOCUMENTS CONSIDERED TO BE RELEVANT | |
|---|---|---|
| Category* | Citation of document, with indication, where appropriate, of the relevant passages | Relevant to claim No. |
| PA | KR 10-2024-0041208 A (LG ENERGY SOLUTION, LTD.) 29 March 2024 (2024-03-29)<br>See paragraphs [0070]-[0078]; claim 1; and figure 4. | 1-11 |

Form PCT/ISA/210 (second sheet) (July 2022)

**INTERNATIONAL SEARCH REPORT**
Information on patent family members

International application No.

**PCT/KR2024/009413**

| Patent document cited in search report | | | Publication date (day/month/year) | Patent family member(s) | | | Publication date (day/month/year) |
|---|---|---|---|---|---|---|---|
| KR | 10-2022-0074797 | A | 03 June 2022 | CN | 115461634 | A | 09 December 2022 |
| | | | | EP | 4152021 | A1 | 22 March 2023 |
| | | | | JP | 2023-519949 | A | 15 May 2023 |
| | | | | JP | 2024-099795 | A | 25 July 2024 |
| | | | | JP | 7483922 | B2 | 15 May 2024 |
| | | | | KR | 10-2024-0109971 | A | 12 July 2024 |
| | | | | KR | 10-2684286 | B1 | 11 July 2024 |
| | | | | US | 11768251 | B2 | 26 September 2023 |
| | | | | US | 2023-0152388 | A1 | 18 May 2023 |
| | | | | US | 2023-0243895 | A1 | 03 August 2023 |
| | | | | WO | 2022-114871 | A1 | 02 June 2022 |
| KR | 10-2023-0052763 | A | 20 April 2023 | CN | 117015715 | A | 07 November 2023 |
| | | | | EP | 4293370 | A1 | 20 December 2023 |
| | | | | JP | 2024-505902 | A | 08 February 2024 |
| | | | | JP | 7508711 | B2 | 01 July 2024 |
| | | | | US | 2024-0133972 | A1 | 25 April 2024 |
| | | | | US | 2024-0230784 | A9 | 11 July 2024 |
| | | | | WO | 2023-063625 | A1 | 20 April 2023 |
| KR | 10-2023-0003838 | A | 06 January 2023 | KR | 10-2672249 | B1 | 05 June 2024 |
| KR | 10-2023-0073447 | A | 26 May 2023 | None | | | |
| KR | 10-2024-0041208 | A | 29 March 2024 | KR | 10-2024-0119025 | A | 06 August 2024 |
| | | | | KR | 10-2690387 | B1 | 05 August 2024 |
| | | | | WO | 2024-063600 | A1 | 28 March 2024 |

Form PCT/ISA/210 (patent family annex) (July 2022)

## REFERENCES CITED IN THE DESCRIPTION

**Patent documents cited in the description**

- KR 1020230091278